# FASCICULE DE BREVET EUROPEEN

(11) **EP 1 687 237 B1**
(45) Date de publication et mention de la délivrance du brevet: **27.04.2011**
(21) Numéro de dépôt: 04797714.5
(22) Date de dépôt: 08.11.2004
(51) Int. Cl.: B81C 1/00

(54) **PROCEDE DE CONTROLE DE L'HERMETICITE D'UNE CAVITE CLOSE D'UN COMPOSANT MICROMETRIQUE, ET COMPOSANT MICROMETRIQUE POUR SA MISE EN OEUVRE**
VERFAHREN ZUR PRÜFUNG DER DICHTHEIT EINES HERMETISCH VERSIEGELTEN MIKROMECHANISCHEN ELEMENTS UND SO ZU PRÜFENDES ELEMENT
METHOD TO TEST THE HERMETICITY OF A SEALED CAVITY MICROMECHANICAL DEVICE AND THE DEVICE TO BE SO TESTED

(30) Priorité: 21.11.2003 EP 03026780
(43) Date de publication de la demande: 09.08.2006
(73) Titulaire: ASULAB S.A., 2074 Marin (CH)
(72) Inventeur: GUEISSAZ, François, CH-2075 Wavre (CH); RANDIN, Jean-Paul, CH-2016 Cortaillod (CH)
(74) Mandataire: Vigand, Philippe
(86) Numéro de dépôt international: PCT/EP2004/012626
(87) Numéro de publication internationale: WO 2005/049482

(56) Documents cités:
- EP-A- 0 874 379
- EP-A- 1 310 380
- US-A- 4 224 565
- US-A- 4 282 744
- US-A- 5 307 139
- US-A1- 2002 096 421
- WAELTI M ET AL: "PACKAGE QUALITY TESTING USING INTEGRATED PRESSURE SENSOR" PROCEEDINGS OF THE SPIE, SPIE, BELLINGHAM, VA, US, vol. 3582, 1 novembre 1998 (1998-11-01), pages 981-986, XP008009786 ISSN: 0277-786X
- NESE M ET AL: "New Method For Testing Hermeticity Of Silicon Sensor Structures" TRANSDUCERS 1995 EUROSENSORS IX, vol. 1, 25 juin 1995 (1995-06-25), pages 260-262, XP010304868 Stockholm

## Description

L'invention concerne un procédé de contrôle de l'herméticité d'une cavité close d'au moins un composant micrométrique. Le composant micrométrique comprend une structure réalisée sur ou dans une portion d'un substrat et un capot fixé sur une zone du substrat pour protéger la structure. La cavité du composant micrométrique est délimitée par la surface intérieure du capot, la structure et la zone du substrat. Cette cavité peut être remplie par exemple d'un gaz inerte à pression voisine de la pression atmosphérique ou peut être une cavité sous vide.

L'invention concerne également le composant micrométrique à cavité close pour la mise en oeuvre du procédé de contrôle. La structure réalisée sur ou dans une portion du substrat peut être un circuit intégré ou une structure tridimensionnelle ou une combinaison d'un circuit intégré et d'une structure tridimensionnelle.

On entend par structures tridimensionnelles de ces composants micrométriques, des dispositifs micro-optoélectromécaniques (MOEMS) ou des dispositifs micro-électromécaniques (MEMS) tels que des contacteurs reed, des accéléromètres, des micro-moteurs, des résonateurs à quartz, des capteurs de taille micrométrique où il est nécessaire de les laisser libres de mouvements après encapsulation dans une atmosphère contrôlée. La construction de ces structures tridimensionnelles des composants micrométriques peut se faire sur un substrat isolant ou sur un substrat semi-conducteur dans lequel des circuits intégrés ont été par exemple préalablement réalisés. Dans ce dernier cas, il est possible de prendre les plages de contact métallique du circuit intégré pour débuter le dépôt des couches métalliques devant constituer en partie la structure du composant micrométrique et pour permettre de le relier électriquement audit circuit.

Dans le brevet EP 0 874 379 du même demandeur, il est décrit un micro-contacteur à lames de taille micrométrique en tant qu'exemple de structure tridimensionnelle et son procédé de réalisation. Le contacteur comprend des lames métalliques distantes l'une de l'autre à l'état de repos qui sont réalisées par voie électrolytique en plusieurs étapes et sont solidaires d'un substrat. Les lames sont constituées d'un alliage de fer et de nickel déposé par procédé électrolytique. Cet alliage a la propriété d'être ferromagnétique pour que les lames puissent être mises en contact l'une avec l'autre lorsqu'un champ magnétique les traversant crée une force d'attraction entre elles. Au moins une ouverture ou un rétrécissement sont pratiqués sur au moins une des lames pour faciliter la flexion de la lame.

Le procédé de contrôle de l'herméticité doit permettre de détecter un taux de fuite de très petites cavités closes de composants micrométriques dont le volume est inférieur à 1 mm³, par exemple de l'ordre de 0,02 mm³. Il est nécessaire de garantir pour la cavité close de ces composants micrométriques de longues constantes de temps d'égalisation d'au moins 20 années afin que la structure de chaque composant soit protégée de tout fluide contaminant. Le fluide contaminant peut être un liquide ou un gaz.

Lorsque le capot du composant micrométrique est fixé sur le substrat pour enfermer la structure à protéger, il peut être observé des micro-fissures susceptibles de permettre à un liquide ou un gaz contaminant de l'extérieur de pénétrer dans la cavité et contaminer ladite structure.

Pour contrôler l'herméticité ou détecter une fuite d'une cavité close d'un composant par une méthode traditionnelle, un gaz de contrôle doit être introduit dans la cavité. Pour ce faire, ledit composant doit être placé dans une enceinte qui est remplie d'un gaz, tel que de l'hélium à une pression élevée afin d'accélérer l'introduction du gaz dans ladite cavité. Cependant, un inconvénient d'une telle méthode est que le gaz de mesure introduit dans la cavité risque de s'échapper partiellement ou entièrement en présence d'une grosse fuite, ce qui peut fausser le contrôle de l'herméticité qui est traditionnellement effectué à l'aide d'un spectromètre de masse.

Un autre inconvénient de la méthode traditionnelle est que le seuil de détection de fuite d'un système à spectromètre de masse est de l'ordre de 5.10⁻¹² mbar·l/s. Ceci ne permet pas de détecter les taux de fuites maxima de l'ordre de 10⁻¹⁵ à 10⁻¹⁴ mbar·l/s qui permettent de garantir des constantes d'égalisation d'au moins 20 années pour des cavités de volume inférieur à 1 mm³.

Dans le brevet US 6,223,586, il est décrit un procédé d'inspection de fuites de composants électroniques, tels que des dispositifs micro-électromécaniques ayant une cavité close. Pour ce faire, des plaquettes de tels composants électroniques sont placées tout d'abord dans un bain de liquide sous pression pendant une période de temps déterminée. Le liquide sous pression peut être par exemple de l'eau. Une fois cette étape terminée, les composants sont placés dans un autre liquide et une inspection par microscope peut être effectuée pour détecter des zones de fuite des cavités de ces composants. Cet autre liquide peut également être de l'eau de manière à éviter que l'eau à l'intérieur de la cavité s'évapore. Un inconvénient majeur d'un tel procédé réside dans le fait que la sensibilité pour le contrôle de l'herméticité est très réduite.

Dans le document "New method for testing Hermeticity of Silicon Sensor Structures" de Nese et.al. - à 8th International Conference on Solid State Sensors and Actuators, and Eurosensors IX - Stockholm Juin 25-29 1995, page 260-262, il est décrit un composant micro-électronique avec une cavité dont l'herméticité est controlé par un procédé optique utilisant un analyse spectrale du gaz dans la cavité. Ce procédé est instantané.

Dans le document de brevet EP 1 310 380, il est décrit un dispositif micromécanique, et son procédé de fabrication. Le dispositif micromécanique comprend une structure d'accéléromètre ou de gyroscope, réalisée sur un substrat, et enfermée sous vide ou à faible pression par un capot. Un matériau getter, tel qu'une couche de titane, est déposé sur le substrat de manière à servir de pompe à vide pour absorber l'oxygène résiduel, et une couche métallique sous forme d'électrode de détection est prévue. Toutefois, aucun élément du dispositif ne permet de contrôler efficacement l'herméticité d'une telle cavité close un taux de fuite faible ou fort.

Dans le document de brevet US 2002/0096421, il est décrit un dispositif micrométrique (MEMS), qui est un micro-contacteur, et son procédé de fabrication. Ce micro-contacteur est enfermé dans une cavité hermétiquement fermée. Il comprend une structure mobile réalisée sur un substrat. Un chemin de signaux, qui comporte une ligne d'entrée espacée d'une ligne de sortie de signaux, est réalisé sur une partie intérieure du capot enfermant la structure mobile dans une cavité close. Ces lignes d'entrée et de sortie peuvent être réalisées par tout type de métaux. Toutefois, ce dispositif micrométrique ne comprend aucun élément susceptible d'être utilisé pour le contrôle de l'herméticité de la cavité close du dispositif micrométrique.

Dans le document de brevet US 4,224,565, il est décrit un composant électronique hermétiquement encapsulé. Ce composant électronique comprend un capteur pour détecter le niveau d'humidité dans la cavité du composant encapsulé. Ce capteur peut comprendre un condensateur dont la valeur capacitive change en présence d'humidité. Toutefois, un tel capteur ne permet pas de contrôler l'herméticité d'une cavité close de petite dimension d'un composant micrométrique.

Dans les documents de brevet GB 1 213 406 US 4,282,744, il est décrit un composant électrique encapsulé et un procédé de test de l'herméticité de l'encapsulation dudit composant. Pour le contrôle de l'herméticité, le composant électrique est placé dans une chambre, qui contient un liquide sous une pression supérieure à la pression atmosphérique, pendant une longue période pour que le liquide soit susceptible de pénétrer par une fuite dans l'encapsulation. Une mesure d'une résistance électrique entre deux conducteurs espacés à l'intérieur de l'encapsulation du composant est effectuée par la suite pour déterminer la présence de liquide dans l'encapsulation. Cependant un tel procédé ne s'applique pas à un composant micrométrique dans une cavité duquel un élément témoin peut servir au contrôle de l'herméticité.

L'invention a donc pour but principal de pallier les inconvénients de l'art antérieur en fournissant un procédé de contrôle de l'herméticité du type cumulatif d'une cavité close d'au moins un composant micrométrique, avec une sensibilité remarquablement accrue. Ce procédé a la capacité de révéler les fuites grossières en une seule opération de détection. Des moyens sont ainsi prévus dans chaque cavité afin de réagir avec une quantité de fluide ayant pénétré dans la cavité pendant une période de temps déterminée pour le contrôle de l'herméticité.

A cet effet, l'invention a pour objet un procédé de mesure de l'herméticité d'une cavité close d'au moins un composant micrométrique cité ci-devant, qui comprend les caractéristiques définies dans les revendications indépendantes 1 et 2.

Un avantage du procédé de contrôle de l'herméticité de la cavité, selon l'invention, réside dans le fait que l'élément témoin placé dans la cavité permet d'absorber ou de réagir avec une certaine quantité de fluide réactif ayant pénétré dans la cavité close. De ce fait, l'élément témoin permet de cumuler l'effet de cette quantité de fluide ayant pénétré dans la cavité et ainsi d'avoir ses propriétés optiques ou électriques modifiées de manière permanente. Grâce à cela, une fuite grossière ou une fine fuite peut être contrôlée de la même manière en une seule opération à l'aide du procédé de contrôle de l'herméticité.

De préférence, plusieurs plaquettes, qui comprennent chacune plusieurs composants micrométriques réalisés sur un même substrat et ayant une plaque de capots fixée sur le substrat pour enfermer chaque structure des composants micrométriques, peuvent être placées dans l'enceinte. Pour réduire le temps de contrôle d'une multitude de composants micrométriques, ces plaquettes sont toutes soumises à la pression du fluide réactif dans l'enceinte pendant une période de temps déterminée. Ces plaquettes peuvent être placées dans l'enceinte en fin du procédé de fabrication desdites plaquettes et avant ou après des opérations de test électriques de chaque composant. Dans chaque cavité des composants micrométriques, un gaz inerte, tel que de l'argon, à pression voisine de la pression atmosphérique peut protéger chaque structure.

Avantageusement, l'enceinte remplie du fluide réactif peut être chauffée à une température supérieure à la température ambiante, de préférence à une température supérieure à 100 °C par des moyens de chauffage pendant la période de temps déterminée. Ceci permet d'accélérer la réaction du fluide réactif, ayant pénétré dans chaque cavité, avec l'élément témoin. Cette accélération de réaction peut également être obtenue à l'aide d'une illumination dans l'ultraviolet (UV).

Avantageusement, l'enceinte est remplie d'un gaz réactif sous pression de préférence supérieure à 10 bars, par exemple 15 bars de manière à accélérer l'introduction du gaz réactif dans les cavités des composants. Comme il doit être garanti un temps d'égalisation d'au moins 20 années de ces composants

L'invention a également pour objet un composant micrométrique convenant à la mise en oeuvre du procédé cité ci-devant, qui comprend les caractéristiques définies dans la revendication 10.

Avantageusement, l'élément témoin est une couche de cuivre ou de titane pour un contrôle par voie optique pour réagir avec de l'oxygène en tant que fluide réactif, ou une résistance en palladium pour un contrôle par voie électrique pour réagir avec de l'hydrogène en tant que fluide réactif. La cavité de chaque composant est préférablement remplie d'un gaz inerte, tel que de l'argon à pression voisine de la pression atmosphérique.

Bien entendu, l'élément témoin, notamment pour un contrôle optique, peut être choisi parmi plusieurs autres matériaux métalliques, tels que l'argent, le zirconium ou le niobium.

Pour un contrôle par voie optique, l'élément témoin est constitué d'une couche de cuivre ou de titane gravée sélectivement ou déposée sélectivement par évaporation sous vide au travers d'un masque sur une partie de la surface intérieure du capot ou sur une partie de la zone du substrat avant l'opération de fixation du capot sur une zone du substrat. L'épaisseur de cette couche de cuivre ou de titane est comprise entre 10 et 100 nm, de préférence sensiblement égale à 30 nm. Dans le cas d'une forme circulaire de l'élément témoin, le diamètre de cette couche de cuivre ou de titane est compris entre 10 et 100 µm, de préférence 70 µm.

Les buts, avantages et caractéristiques du procédé de mesure de l'herméticité d'une cavité d'un composant micrométrique, ainsi que dudit composant micrométrique apparaîtront mieux dans la description suivante de modes de réalisation de l'invention en liaison avec les dessins dans lesquels :
La figure 1 représente une vue tridimensionnelle en coupe partielle d'un composant micrométrique représentant un micro-contacteur magnétostatique, selon une première forme d'exécution, dans lequel un élément témoin peut être contrôlé par voie optique pour le contrôle de l'herméticité,
la figure 2 représente une vue tridimensionnelle en coupe partielle d'un composant micrométrique représentant un micro-contacteur magnétostatique, selon une seconde forme d'exécution, dans lequel un élément témoin peut être mesuré par voie optique pour le contrôle de l'herméticité,
la figure 3 représente de manière simplifiée une coupe verticale d'une enceinte thermique dans laquelle sont placées des plaquettes de composants micrométriques pour la mise en oeuvre du procédé de contrôle d'herméticité selon l'invention,
la figure 4 représente de manière simplifiée une vue tridimensionnelle d'une machine de mesure pour un contrôle par voie optique de l'élément témoin de certains composants micrométriques d'une plaquette de composants pour la mise en oeuvre du procédé de contrôle d'herméticité selon l'invention,
la figure 5 représente schématiquement une coupe partielle d'une partie d'une plaquette de composants micrométriques de la première forme d'exécution de la figure 1, et des moyens de contrôle de la machine de mesure pour la mise en oeuvre du procédé de contrôle de l'herméticité selon l'invention,
la figure 6 représente schématiquement une coupe partielle d'une partie d'une plaquette de composants micrométriques de la seconde forme d'exécution de la figure 2, et des moyens de contrôle de la machine de mesure pour la mise en oeuvre du procédé de contrôle de l'herméticité selon l'invention,
la figure 7 représente une vue tridimensionnelle en coupe partielle d'un composant micrométrique à micro-contacteur, selon une troisième forme d'exécution, dans lequel un élément témoin peut être contrôlé par voie électrique pour le contrôle de l'herméticité,
la figure 8 représente un graphique de la pression partielle d'oxygène en fonction du temps d'exposition dans une cavité close d'un composant micrométrique pour un procédé de contrôle de l'herméticité par voie optique selon l'invention, et
la figure 9 représente des graphiques de la transmission optique d'une couche de cuivre oxydée, d'une couche non oxydée et du rapport de contraste entre des couches de cuivre oxydée et non oxydée en fonction de la longueur d'onde d'un faisceau de lumière traversant ladite couche pour le procédé de contrôle par voie optique selon l'invention.

Dans la description suivante, les moyens de mise en oeuvre du procédé de contrôle de l'herméticité d'une cavité close d'au moins un composant micrométrique, qui sont bien connus d'un homme du métier, ne sont représentés et expliqués que de manière simplifiée.

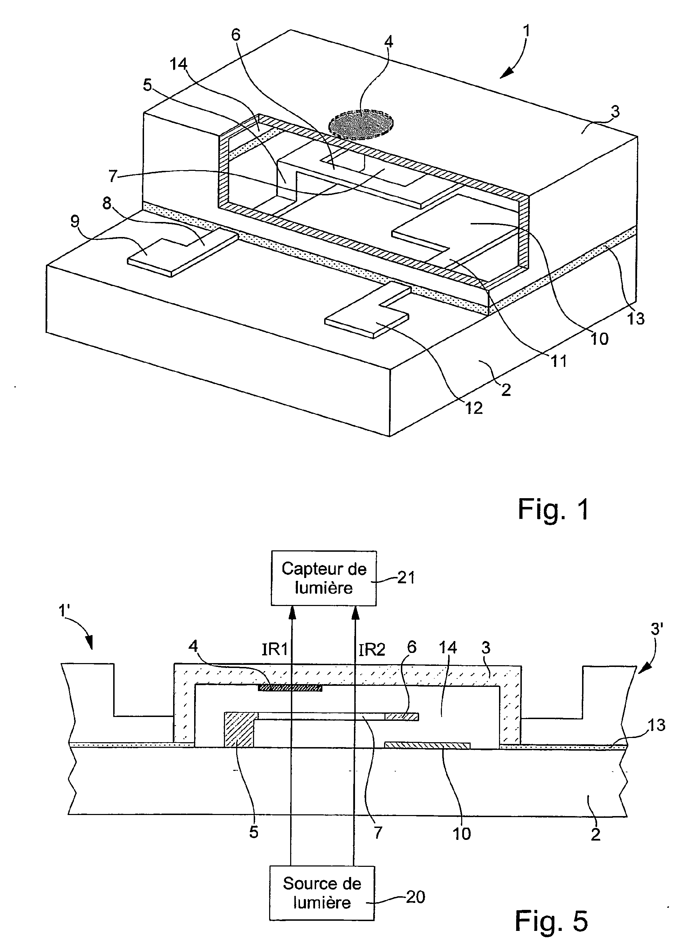

A la figure 1, il est représenté une première forme d'exécution préférée d'un composant micrométrique 1 pour la mise en oeuvre du procédé de contrôle de l'herméticité par voie optique. Ledit composant micrométrique 1, représenté sur la figure 1, provient d'une plaquette de plusieurs composants micrométriques, qui sont réalisés sur un même substrat semi-conducteur 2, tel qu'en silicium, ou en verre, après l'opération de sciage de ladite plaquette. Toutefois pour le procédé de contrôle de l'herméticité d'une cavité close 14 d'au moins un composant micrométrique 1, il peut s'agir d'un composant séparé de la plaquette ou d'au moins un composant de la plaquette avant une opération de sciage. La plaquette non représentée à la figure 1 peut comprendre des milliers de composants micrométriques.

Le composant micrométrique 1 comprend une structure tridimensionnelle 5, 6 et 10 réalisée sur une portion d'un substrat 2, un capot 3 de protection de la structure fixé sur une zone du substrat 2 et un élément témoin 4 sensible à un fluide réactif spécifique. L'élément témoin 4 est placé sur une partie supérieure de la surface intérieure du capot 3 dans cette première forme d'exécution. Une cavité close 14 est délimitée par la surface intérieure du capot 3, la structure tridimensionnelle 5, 6 et 10 et la zone du substrat 2.

Le volume d'une cavité 14 d'un tel composant micrométrique 1 est de l'ordre de 0,02 mm³ (1000 µm de long, 200 µm de large et 100 µm de haut). Cette cavité 14 à très faible volume est remplie de préférence d'un gaz inerte, tel que de l'argon, à pression voisine de la pression atmosphérique.

La structure tridimensionnelle 5, 6 et 10 peut être un micro-contacteur magnétique. Pour des détails techniques de réalisation de ce micro-contacteur, le lecteur peut se référer au document EP 0 874 379 du même Demandeur qui est cité en référence.

Ce micro-contacteur est composé d'une première lame conductrice 6, dont une extrémité est solidaire du substrat 2 par l'intermédiaire d'un pied conducteur 5, et l'autre extrémité de la première lame est libre de mouvement, et d'une seconde lame conductrice 10 fixée sur le substrat. Chaque lame métallique 6 et 10, ainsi que le pied conducteur 5 peuvent être obtenus par un procédé électrolytique. En présence d'un champ magnétique, l'extrémité libre de la première lame 6 peut venir en contact de la seconde lame 10.

Une première piste conductrice 8 relie le pied conducteur 5 de la première lame 6 à une première borne de contact électrique 9 placée à l'extérieur de la cavité 14 sur le substrat 2. Une seconde piste conductrice 11 relie la seconde lame 10 à une seconde borne de contact électrique 12 placée à l'extérieur de la cavité 14 sur le substrat 2. Chaque borne de contact 9 et 12 peut être connectée à des bornes de contact d'un circuit électronique ou à des bornes de contact d'un appareil électronique. Un circuit intégré non représenté peut être réalisé en dessous du micro-contacteur et relié électriquement à chaque lame métallique 6 et 10 dudit micro-contacteur. Bien entendu, la connexion électrique du micro-contacteur vers l'extérieur de la cavité 14 peut également être réalisée à l'aide de trous métallisés à travers le substrat 2 ou d'une autre manière que celle présentée à la figure 1.

Une partie intermédiaire de la première lame 6 du micro-contacteur a une ouverture 7 s'étendant sur la majeure partie de sa longueur pour faciliter la flexion de la lame 6. La distance séparant le pied 5 de la première lame 6 et une extrémité de la seconde lame 10 correspond approximativement à la longueur de l'ouverture 7.

L'élément témoin 4, utilisé pour le contrôle de l'herméticité de la cavité close 14 du composant micrométrique 1, est de préférence une couche de cuivre, mais peut être également une couche de titane, qui est placée distante et en regard de l'ouverture 7. Cette couche de cuivre, voire de titane peut être obtenue par gravure chimique sélective ou par dépôt sélectif par évaporation sous vide sur une partie supérieure de la surface intérieure du capot avant la fixation du capot 3 sur le substrat 2. La technique de gravure chimique peut être difficile à mettre en oeuvre pour réaliser la couche de cuivre ou de titane dans une cavité. Il est donc préférable d'utiliser la technique du dépôt par évaporation sous vide du cuivre, voire du titane dans cette première forme d'exécution. De préférence, il est déposé une couche de cuivre qui est facile à réaliser par cette méthode de dépôt.

Bien entendu, le dépôt par évaporation sous vide de la couche de cuivre, voire de la couche de titane peut être réalisé pendant les étapes de fabrication des plaquettes de composants micrométriques. Pour ce faire, des capots sont tout d'abord réalisés par exemple par gravure chimique dans une plaque en verre ou en silicium. Après cette étape, la couche de cuivre ou de titane est déposée sélectivement en même temps sur la surface intérieure des capots 3 d'au moins une plaque de capots à travers un masque dans lequel des trous de dimension sensiblement égale à la dimension de la couche de cuivre à déposer sont réalisés. Le masque utilisé peut être par exemple un masque en verre photo-structurable du type Foturan de la maison Schott Glas en Allemagne.

Une fois que les couches de cuivre sont déposées sélectivement sur chaque surface intérieure des capots 3 de la plaque de capots, la plaque est fixée sur le substrat 2 de la plaquette. Ainsi chaque capot 3 de la plaque est fixé sur chaque zone correspondante du substrat 2 afin d'enfermer un micro-contacteur respectif à protéger de la plaquette. Cette plaque de capots peut être par exemple du verre ou du silicium.

L'épaisseur de cette couche de cuivre est comprise entre 10 et 100 nm, de préférence sensiblement égale à 30 nm pour permettre à un faisceau de lumière de longueur d'onde déterminée de traverser ladite couche pour un contrôle d'herméticité par voie optique. Il est à noter que plus l'épaisseur de la couche de cuivre est petite et plus la sensibilité est grande, mais avec un contraste diminué. Il a donc dû être trouvé un compromis entre contraste et sensibilité ce qui fait que l'épaisseur de la couche de cuivre a été choisie de préférence égale à 30 nm.

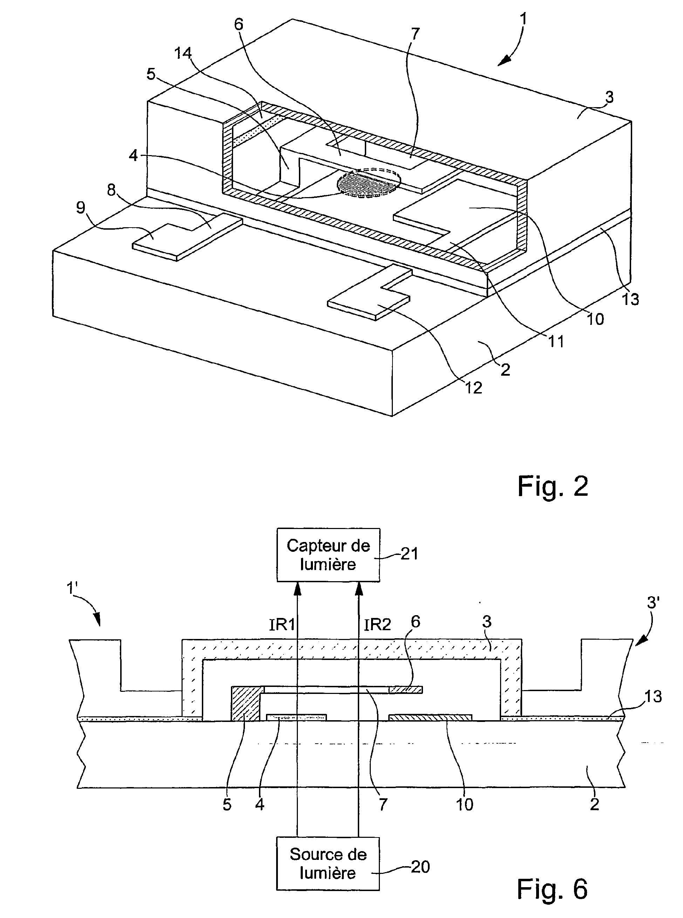

La dimension de la surface de la couche de cuivre peut être de dimension inférieure à la dimension de la surface de l'ouverture 7 du micro-contacteur. Ceci permet de définir à travers l'ouverture 7 des première et seconde zones de mesure comme expliqué ci-après en référence notamment aux figures 5 et 6. Dans le cas d'une surface circulaire de ladite couche, le diamètre de cette couche peut être approximativement de 70 µm afin d'être facilement mesurable par voie optique à l'aide de moyens traditionnels. Ainsi, chaque couche de cuivre 4 déposée sur la surface intérieure de chaque capot 3 a une masse d'environ 1,03 ng ou 1,63·10⁻¹¹ mole.

La fixation du capot 3 ou de chaque capot de la plaque de capots sur chaque zone du substrat 2 est faite par un joint annulaire de glas frit ou de préférence par un anneau d'alliage métallique 13. L'alliage métallique peut être un alliage composé d'or et d'étain (Au-Sn) à point de fusion de l'ordre de 280°C. Bien entendu, il est nécessaire que l'alliage métallique choisi assure une bonne adhérence sur les matériaux choisis du substrat 2 et du capot 3. Avec une fixation du capot par cet alliage métallique, il doit être prévu une couche d'isolation traditionnelle, non représentée, sur les pistes conductrices 8 et 11.

A la figure 2, il est représenté une seconde forme d'exécution préférée d'un composant micrométrique 1 pour la mise en oeuvre du procédé de contrôle de l'herméticité par voie optique. Il est à noter que les éléments de la figure 2, qui correspondent à ceux de la figure 1, portent des signes de référence identiques. De ce fait par simplification, il ne sera pas répété la description de ces éléments.

La différence essentielle de cette seconde forme d'exécution par rapport à la première forme d'exécution du composant micrométrique est le fait que la couche de cuivre ou de titane 4 est réalisée directement sur le substrat 2 par exemple avant la réalisation du micro-contacteur. Cette couche de cuivre ou de titane 4 est positionnée en regard de l'ouverture 7. La dimension de la surface de la couche est inférieure à la dimension de la surface de l'ouverture. Ceci permet de définir des première et seconde zone de mesure à travers l'ouverture pour un contrôle par voie optique dans le sens vertical du composant.

Il est possible de réaliser cette couche de cuivre ou de titane 4 par des techniques de gravure chimique sélective ou de dépôt par évaporation sous vide comme expliqué ci-devant. Il est à noter que la gravure chimique dans cette seconde forme d'exécution peut aussi être employée étant donné que la couche de cuivre est réalisée sur une surface plane du substrat 2, par exemple sur une couche d'isolation.

Comme les couches de cuivre ou de titane de cette seconde forme d'exécution sont réalisées lors des étapes de fabrication des plaquettes sur le substrat, le temps de fabrication desdites plaquettes peut être plus lent que le temps de fabrication des plaquettes de la première forme d'exécution des composants micrométriques. Cependant, les dimensions de cette couche de cuivre, voire de titane pour chaque capot 3 peuvent être équivalentes à celles mentionnées dans la première forme d'exécution.

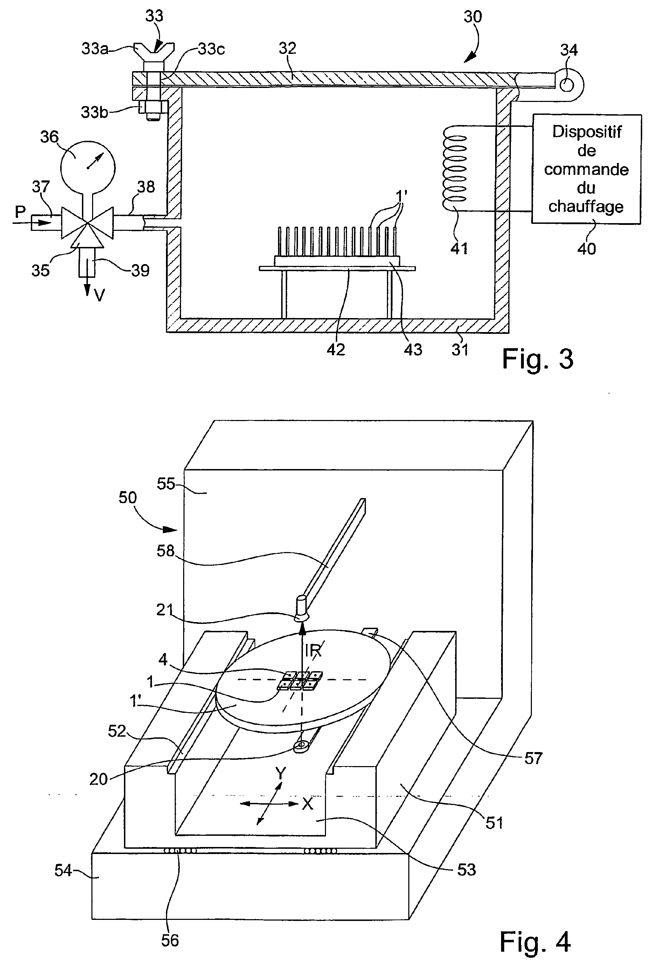

En référence à la figure 3, une enceinte thermique 30 est représentée de manière très simplifiée pour l'explication des premières étapes du procédé de contrôle de l'herméticité de plusieurs composants micrométriques. Bien entendu, tous les éléments de cette enceinte peuvent prendre diverses formes autres que celles présentées sur la figure 3 pour autant que les premières étapes du procédé puissent être réalisées normalement.

L'enceinte thermique 30 comprend essentiellement une cuve 31 et un couvercle 32 articulé autour d'un axe de rotation 34 à l'embouchure de la cuve 31. Des moyens de fermeture 33 sont prévus pour fermer hermétiquement l'enceinte 30 en appliquant le couvercle 32 sur le bord supérieur de la cuve 31. Ces moyens de fermeture 33 sont par exemple constitués par une vis 33a, dont la tête vient en appui contre une surface supérieure du couvercle 32, et un écrou 33b en appui sur la surface inférieure du bord supérieur de la cuve 31. La tige de la vis 33a traverse une ouverture 33c qui est pratiquée dans le couvercle 32 et sur le bord supérieur de la cuve 31 pour être vissée dans l'écrou 33b. La tête de la vis 33a a une forme adaptée à une manipulation manuelle. Une garniture d'étanchéité non représentée doit en outre être prévue au niveau du contact entre le bord supérieur de la cuve 31 et le couvercle 32 pour assurer une fermeture hermétique de l'enceinte 30.

L'enceinte thermique 30 comprend encore des moyens d'introduction 35 à 39 du fluide réactif, notamment de l'oxygène à l'intérieur de la cuve 31, et des moyens de chauffage 40 et 41 pour chauffer l'intérieur de la cuve 31. Les moyens de chauffage sont constitués principalement par un corps de chauffe 41 disposé à l'intérieur de l'enceinte et d'un dispositif de commande du chauffage 40 qui contrôle le corps de chauffe pour obtenir une température souhaitée dans l'enceinte 30.

Les moyens d'introduction de l'oxygène sous pression dans la cuve sont constitués par une vanne à trois voies 35, et d'un appareil de mesure de la pression 36 à l'intérieur de l'enceinte 30. Une première conduite 37 de la vanne à trois voies 35 est reliée à une bombonne d'oxygène non représentée pour remplir, par une seconde conduite 38 de la vanne 35, l'enceinte d'oxygène à une pression p lorsque les première et seconde conduites sont ouvertes et la troisième conduite 39 est fermée. A la fin des premières étapes du procédé de contrôle, l'enceinte 30 est dépressurisée en retirant l'oxygène sous pression dans l'enceinte. Pour ce faire, les seconde et troisième conduites 38 et 39 sont ouvertes et la première conduite 37 est maintenue fermée.

Les premières étapes du procédé de contrôle de l'herméticité sont expliquées ci-après de manière plus précise. Tout d'abord, plusieurs plaquettes 1' de composants micrométriques sont placées dans un réceptacle ouvert 43. Ce réceptacle 43 portant les plaquettes 1' est posé ensuite sur un socle 42 disposé sur le fond de la cuve 31 de l'enceinte 30.

L'enceinte 30 est ensuite fermée hermétiquement par les moyens de fermeture 33 en plaçant le couvercle 32 en appui contre le bord supérieur de la cuve 31. Une fois que l'enceinte 30, qui comprend les plaquettes 1' de composants micrométriques, est hermétiquement fermée, les première et seconde conduites 37 et 38 de la vanne 35 sont ouvertes alors que la troisième conduite 39 est fermée. De cette façon, l'enceinte 30 peut être remplie d'oxygène à une pression déterminée, qui peut être contrôlée par l'appareil de mesure 36. Bien entendu, la vanne peut être électroniquement commandée de manière à fermer toutes les conduites 37 à 39 quand l'oxygène à l'intérieur de l'enceinte est à la pression déterminée souhaitée.

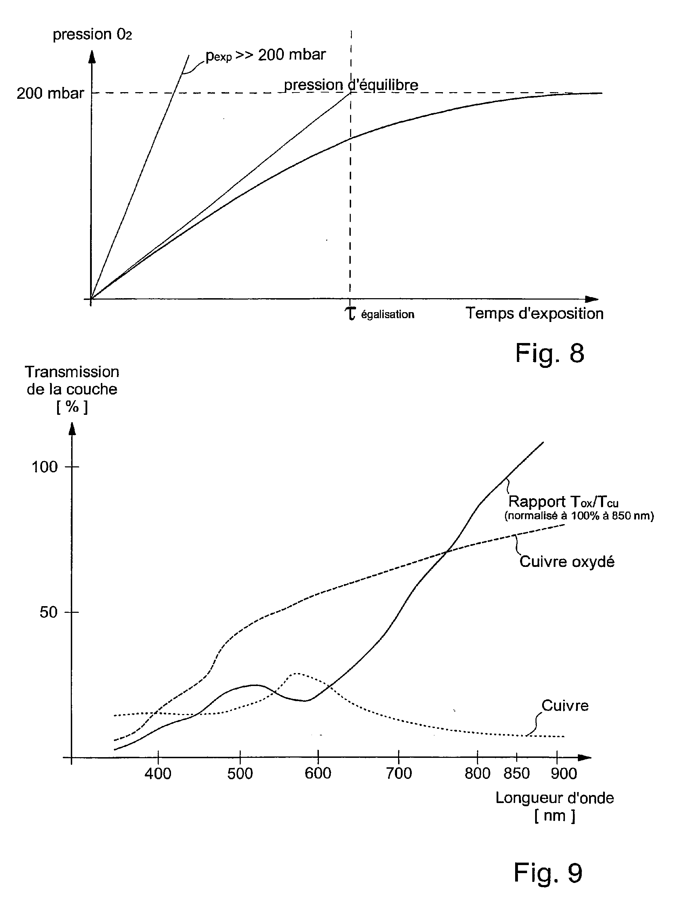

La pression d'oxygène dans l'enceinte 30 peut être supérieure à 10 bars et de préférence sensiblement égale à 15 bars ou 20 bars. Ainsi, tous les composants micrométriques sont soumis à une pression d'oxygène élevée. De cette manière, la période de temps nécessaire à introduire une quantité détectable d'oxygène dans chaque cavité et permettant de garantir un temps d'égalisation supérieur à 20 années peut être fortement réduite comme expliqué ci-dessous notamment en référence aux figures 8 et 9.

Pour s'assurer que l'oxygène introduit va rapidement réagir avec l'élément témoin en cuivre, l'enceinte est chauffée par les moyens de chauffage à une température supérieure à 100°C, par exemple à 150 °C. La période de temps déterminée pour causer une oxydation de la couche de cuivre en tant qu'élément témoin de chaque cavité, si de l'oxygène a pénétré dans la cavité, est ainsi réduite à quelques heures, voire quelques jours (65 h). Comme plusieurs plaquettes d'environ 5'000 composants chacune sont placées dans l'enceinte, il est possible de réaliser ces premières étapes du procédé pour près de 500'000 composants micrométriques en même temps, ce qui procure un gain de temps considérable. De plus, la méthode de mesure optique sur plaque avant le sciage permet une vérification rapide de l'herméticité.

Pour mieux comprendre le gain de temps obtenu par les premières étapes du procédé pour assurer l'herméticité de la cavité close des composants micrométriques, il est fait référence tout d'abord à la figure 8. Sur cette figure 8, il est représenté un graphique de la pression partielle d'oxygène en fonction du temps d'exposition dans une cavité close d'un composant micrométrique.

Lorsque le composant micrométrique est placé dans une ambiance normale à l'air libre, ledit composant est en présence d'environ 20% d'oxygène, ce qui correspond à une pression partielle de 200 mbar d'oxygène à l'équilibre. Comme la cavité du composant micrométrique est remplie uniquement d'un gaz inerte, tel que de l'argon, à une pression par exemple de 800 mbar, il y a donc un écart de 200 mbar d'oxygène entre l'extérieur et l'intérieur de la cavité. De ce fait, en cas de fuite de la cavité, l'oxygène va rentrer progressivement dans ladite cavité de manière asymptotique exponentielle jusqu'à un équilibre de la pression partielle d'oxygène.

Dès l'instant où le composant micrométrique est placé à l'air libre, la pression partielle d'oxygène à l'intérieur de la cavité en fonction du temps peut être définie par la formule p=p₀·(1-e^{(-t/T)}). Dans cette formule, p₀ est la pression d'équilibre d'oxygène à savoir 200 mbar, et T la constante de temps d'échange déterminée par le taux de fuite. Cette constante de temps d'échange doit être d'au moins 20 années pour assurer une herméticité suffisante de la cavité dans la plupart des cas de composants micrométriques. La pente de la courbe à l'origine est donc définie par p₀/T. En soumettant les composants micrométriques dans l'enceinte fermée à une pression d'oxygène par exemple de 20 bars, la pente à l'origine est plus importante et on accélère la vitesse d'introduction d'oxygène par un facteur 100.

Il est à noter que la couche de cuivre utilisée comme élément témoin dans chaque cavité peut s'oxyder en quelques heures en présence de pressions partielles d'oxygène supérieures ou égales à environ 1 mbar, c'est-à-dire environ 100 fois inférieures à la pression d'équilibre. De ce fait, lorsque les composants micrométriques sont soumis à une pression d'oxygène de 15 bars ou de 20 bars à une température par exemple de 120 ou 150 °C, la couche de cuivre a tendance à s'oxyder simultanément à l'introduction d'oxygène à l'intérieur de la cavité.

Dans chaque cavité close de volume V proche de 0,02 mm³, la masse de cuivre est d'environ 1,03 ng avec une couche de cuivre de 70 µm de diamètre et une épaisseur de 30 nm. Avec une telle couche de cuivre, il suffit de 4,08·10⁻¹² mole d'oxygène pour former une couche d'oxyde de cuivre facile à détecter optiquement en transmission. Pour garantir une constante de temps d'égalisation de 20 années avec une pression partielle ambiante de 200 mbar, le taux de fuite défini par la formule L= p₀·V/T est de 6,34·10¹⁵ mbar·l/s. Par conversion en flux moléculaire défini par la formule (dn/dt)= L/R·T où R vaut 8,31 J/K·mole et T vaut 393 K, on trouve que la fuite d'oxygène doit être inférieure à 1,94·10⁻¹⁹ mole/s.

Dans une enceinte à 20 bars d'oxygène, cette fuite sera 100 fois plus forte, c'est-à-dire 1,94·10⁻¹⁷ mole/s. Ainsi, il faut un peu plus de 58 h d'exposition des plaquettes de composants micrométriques dans l'enceinte pour pouvoir introduire les 4,08·10⁻¹² mole d'oxygène nécessaire à une oxydation quantifiable de la couche de cuivre. Comme décrit ci-dessus, il faut atteindre au moins 1 mbar de pression d'oxygène dans la cavité, ce qui représente 4,9·10⁻¹³ mole, ce qui correspond à un temps mort supplémentaire de 7 h indépendant du volume de la cavité. Ainsi, les plaquettes de composants micrométriques doivent être laissées dans l'enceinte sous une pression d'oxygène de 20 bars à une température de 120°C pendant une période de temps déterminée de 65 h.

Après la période de temps déterminée, l'enceinte 30 montrée à la figure 3 est dépressurisée en ouvrant les seconde et troisième conduites 38 et 39, et refroidie. Puis l'enceinte est ouverte pour sortir le réceptacle 43 portant les plaquettes 1' pour les opérations de contrôle optique du procédé selon l'invention. Ces opérations de contrôle optique sont expliquées notamment en référence aux figures 4 à 6 et 9.

A la figure 4, il est représenté une machine de mesure 50 pour le contrôle par voie optique de l'herméticité de la cavité d'au moins certains composants 1 des plaquettes 1'. Tous les éléments de la machine, qui sont bien connus dans le domaine technique de contrôle optique, sont représentés de manière très simplifiée. Bien entendu, chaque élément représenté pour la mesure optique peut être d'une forme différente de celle présentée sur cette figure 4.

La machine de mesure 50 comprend une base 54 sur laquelle est monté un support mobile 51 qui peut être déplacé selon les directions X et Y. Des moyens 56 schématiquement représentés servent de guidage du support mobile 51 sur la base 54. Le support mobile 51 comprend un évidemment 53 en son centre lui conférant une forme en U. Un rebord 52 du côté de l'évidemment 53 est pratiqué sur la partie supérieure du support mobile 51 afin de pouvoir positionner et maintenir une plaquette 1' de composants micrométriques 1 à contrôler. La plaquette 1' est ainsi positionnée distante de la partie basse de l'évidemment 53.

Pour la mesure optique, la machine de mesure 50 comprend une source de lumière 20 fixée à l'extrémité libre d'un bras 57 dont l'autre extrémité est fixée à une paroi frontale 55 de la machine de mesure 50. La machine de mesure comprend encore un capteur d'image 21 fixé à l'extrémité libre d'un bras 58, dont l'autre extrémité est fixée à la paroi frontale de la machine. Des moyens d'alimentation en électricité et de traitement des informations non représentés sont disposés dans la machine de mesure.

Le bras 57 portant à son extrémité libre la source de lumière 20 est situé dans l'évidemment 53 prévu sur le support mobile 51 entre la partie basse du support et le dos de la plaquette 1' à contrôler. Après avoir positionné la plaquette 1' de composants micrométriques à l'aide du support mobile 51 pour le contrôle de l'élément témoin 4 d'un des composants 1, la source de lumière 20 est enclenchée. Cette source de lumière 20 fournit au moins un faisceau de lumière IR d'une longueur d'onde déterminée qui traverse perpendiculairement la plaquette dans une des zones de mesure du composant micrométrique 1 positionné. Le capteur d'image positionné au dessus de la plaquette 1' reçoit le faisceau de lumière IR afin de déterminer en fonction de la transparence, voire de la couleur de la couche de cuivre l'herméticité dudit composant.

La longueur d'onde du faisceau de lumière de la source de lumière doit être proche de 850 nm dans l'infrarouge proche si le substrat et chaque capot sont réalisés en verre, ou proche de 1,3 µm si le substrat et/ou chaque capot sont réalisés dans un matériau semi-conducteur, tel que du silicium. Dans le premier cas, il peut être utilisé des diodes LED (880 nm ou 950 nm) ou un laser semi-conducteur (780 nm) comme source de lumière 20 et un capteur du type CCD comme capteur d'image 21. Dans le second cas, il est utilisé un laser semi-conducteur à 1,3 µm, et un imageur infrarouge adéquat comme capteur d'image 21.

De préférence, comme montré dans les deux formes d'exécution des figures 5 et 6, un premier faisceau de lumière IR1 émis par la source de lumière traverse un composant micrométrique 1 de la plaquette 1' en passant par la première zone de mesure de l'ouverture 7 à travers la couche de cuivre 4 afin d'être capté par le capteur d'image 21. Ensuite de quoi après avoir déplacé la plaquette 1', un second faisceau de lumière IR2 émis par la source de lumière traverse ledit composant en passant par la seconde zone de mesure de l'ouverture 7 à côté de la couche de cuivre. De cette façon une mesure optique comparative peut être réalisée. Cette mesure comparative peut permettre aux moyens de traitement de l'information de calculer un rapport relatif de la transmission optique entre une couche de cuivre oxydée et une couche de cuivre non oxydée. Ainsi, un contrôle d'herméticité ou un taux de fuite du composant peut être déterminé.

La figure 9 représente un graphique de transmission optique des couches de cuivre de 30 nm d'épaisseur dans un état oxydé ou dans un état non oxydé en fonction de la longueur d'onde du faisceau de lumière. On remarque bien sur cette figure 9, que la différence de transmission d'un faisceau de lumière à travers une couche de cuivre oxydée et une couche de cuivre non oxydée augmente avec la longueur d'onde au-delà de 580 nm.

Alors que la couche de cuivre devient de plus en plus opaque vers l'infrarouge, l'oxyde de cuivre devient lui de plus en plus transparent, d'où un contraste de mesure élevé. En déterminant le rapport de transmission Tox/Tcu entre la couche de cuivre oxydée et la couche de cuivre non oxydée, on obtient une référence définie à 100% à 850 nm de longueur d'onde du faisceau de lumière fourni par la source de lumière et capté par le capteur d'image. On constate que le rapport de transmission dans l'infrarouge est supérieur à 10, alors que dans le vert, ce facteur est inférieur à 2,5.

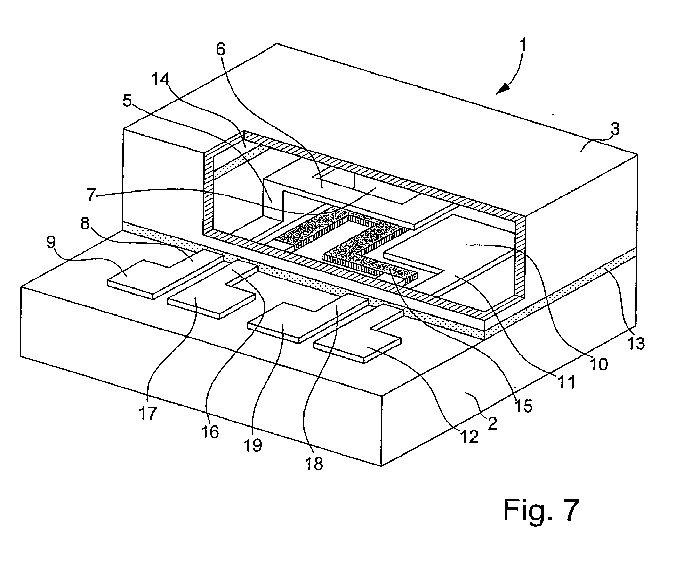

A la figure 7, il est représenté une troisième forme d'exécution d'un composant micrométrique 1 pour la mise en oeuvre du procédé de contrôle de l'herméticité par voie électrique. Il est à noter que les éléments de la figure 7, qui correspondent à ceux des figures 1 et 2, portent des signes de référence identiques. De ce fait par simplification, il ne sera pas répété la description de ces éléments.

Pour le contrôle de l'herméticité de la cavité 14 du composant micrométrique 1 par voie électrique, il est prévu en lieu et place d'une couche de cuivre, d'une résistance en palladium 15 logée intégralement dans ladite cavité close. De manière à avoir une valeur de résistance significative susceptible de pouvoir être aisément mesurée par un appareil de mesure, la résistance décrit un serpentin dans la cavité. Bien entendu, la longueur du serpentin peut être beaucoup plus grande que ce qui est illustré à la figure 7. Cette résistance en palladium peut être réalisée par un procédé électrolytique, par gravure chimique, ou d'une autre manière connue.

Une troisième piste conductrice 16 relie une première extrémité de la résistance 15 à une troisième borne de contact électrique 17 placée à l'extérieur de la cavité 14 sur le substrat 2. Une quatrième piste conductrice 18 relie une seconde extrémité de la résistance 15 à une quatrième borne de contact 19 placée à l'extérieur de la cavité 14 sur le substrat 2. Chaque borne de contact 17 et 19 peut être connectée à des bornes de contact d'un circuit électronique ou à des bornes de contact d'un appareil électronique de mesure non représentés.

La valeur de la résistance en palladium à la faculté de changer en présence d'hydrogène en tant que fluide réactif. Il est à noter que le palladium possède la propriété d'absorber à température ambiante jusqu'à 900 fois son volume d'hydrogène. Ceci correspond à une fraction atomique d'environ 50%. De ce fait, grâce à cette résistance 15 en palladium dans la cavité 14 du composant micrométrique 1 et au procédé de contrôle décrit ci-devant, il est possible de contrôler par voie électrique l'herméticité de ladite cavité close ou définir un taux de fuite de cette cavité.

Grâce aux éléments témoins placés dans chaque cavité des composants micrométriques d'une ou plusieurs plaquettes de composants, il est possible d'effectuer des mesures indirectes par cumul dans l'élément témoin du fluide réactif ayant pénétré dans la cavité. L'élément témoin dans la cavité change ses propriétés optiques ou électriques en fonction du gaz réactif introduit dans ladite cavité. Ceci procure l'avantage qu'il est possible d'employer le même procédé de contrôle de l'herméticité pour des composants micrométriques ayant des fuites grossière ou fine de leur cavité.

A partir de la description qui vient d'être faite, de multiples variantes de réalisation du procédé de contrôle de l'herméticité d'une cavité close d'au moins un composant micrométrique peuvent être conçues par l'homme du métier sans sortir du cadre de l'invention définie par les revendications. Dans le cas d'un contrôle par voie optique, il peut être prévu d'opérer une mesure de la couche de cuivre par réflexion d'un faisceau de lumière sur la couche de cuivre en lieu et place d'une transmission à travers le composant micrométrique. Cette couche de cuivre peut recouvrir complètement la surface intérieure de chaque capot et/ou chaque zone intérieure du substrat. Le contrôle optique de la couche de cuivre peut être pratiqué à l'aide de moyens de mesure disposés dans l'enceinte, ou visuellement sous un microscope par exemple.

## Revendications

1. Procédé de contrôle de l'herméticité d'une cavité close (14) d'au moins un composant micrométrique (1) qui comprend une structure (5, 6, 10) réalisée sur ou dans une portion d'un substrat (2) et un capot (3) fixé sur une zone du substrat pour protéger la structure, la cavité étant délimitée par la surface intérieure du capot, la structure et la zone du substrat, le procédé étant **caractérisé en ce qu'**il comprend des étapes consistant à :
- placer le composant micrométrique (1) dans une enceinte (30), ledit composant comprenant à l'intérieur de la cavité (14) un élément témoin (4) pour le contrôle d'herméticité dont les propriétés optiques changent de manière permanente en présence d'un fluide réactif susceptible de réagir avec l'élément témoin,
- fermer hermétiquement l'enceinte qui comprend ledit composant,
- remplir l'enceinte d'un fluide réactif sous pression pour soumettre ledit composant à une pression du fluide supérieure à la pression dans la cavité pendant une période de temps déterminée, telle que quelques jours, l'enceinte comprenant des moyens (35 à 39) pour l'introduction du fluide réactif, et
- contrôler la variation des propriétés de l'élément témoin (4) par voie optique en fonction de la quantité de fluide réactif ayant pénétré dans la cavité (14) et réagi avec l'élément témoin pour déterminer l'herméticité de ladite cavité.

2. Procédé de mesure de l'herméticité d'une cavité close (14) d'au moins un composant micrométrique (1) qui comprend une structure (5, 6, 10) réalisée sur ou dans une portion d'un substrat (2) et un capot (3) fixé sur une zone du substrat pour protéger la structure, la cavité étant délimitée par la surface intérieure du capot, la structure et la zone du substrat, la cavité comprenant un gaz inerte, tel que de l'argon, à pression voisine de la pression atmosphérique, le procédé étant **caractérisé en ce qu'**il comprend des étapes consistant à :
- placer le composant micrométrique (1) dans une enceinte (30), ledit composant comprenant à l'intérieur de la cavité un élément témoin (15) pour le contrôle d'herméticité dont les propriétés électriques changent de manière permanente en présence d'un fluide réactif susceptible de réagir avec l'élément témoin, l'élément témoin étant une résistance en palladium réalisée sur une partie de la zone du substrat, des pistes conductrices (16, 18) isolées reliant la résistance et traversant le composant micrométrique pour le contrôle des propriétés électriques,
- fermer hermétiquement l'enceinte qui comprend ledit composant,
- remplir l'enceinte d'un fluide réactif, qui est de l'hydrogène, sous pression pour soumettre ledit composant à une pression d'hydrogène supérieure à 10 bars, de préférence sensiblement égale à 15 bars ou 20 bars pour que la valeur de la résistance en palladium se modifie en fonction de la quantité d'hydrogène ayant pénétré dans la cavité pendant une période de temps déterminée, telle que quelques jours, l'enceinte comprenant des moyens pour l'introduction (35 à 39) de l'hydrogène, et
- contrôler électriquement la variation des propriétés électriques de la résistance en palladium en fonction de la quantité d'hydrogène ayant pénétré dans la cavité et réagi avec la résistance en palladium pour déterminer l'herméticité de ladite cavité.

3. Procédé selon l'une des revendications précédentes, **caractérisé en ce que** plusieurs plaquettes (1'), qui comprennent chacune plusieurs composants micrométriques (1) réalisés sur un même substrat (2) et ayant une plaque (3') de capots (3) fixée sur le substrat pour enfermer chaque structure des composants micrométriques, sont placées dans l'enceinte (30) pour être mises sous pression par le fluide réactif introduit dans l'enceinte pendant une période de temps déterminée.

4. Procédé selon la revendication 3, **caractérisé en ce que** l'intérieur de l'enceinte (30) remplie du fluide réactif est chauffée à une température supérieure à la température ambiante, de préférence à une température supérieure à 100 °C par des moyens de chauffage (40, 41) pendant la période de temps déterminée.

5. Procédé selon la revendication 1, pour lequel la cavité (14) du composant micrométrique (1) ou chaque cavité de composants micrométriques, réalisés sur un même substrat (2) d'au moins une plaquette (1') et ayant une plaque (3') de capots (3) fixée sur le substrat pour enfermer chaque structure des composants micrométriques, comprend un gaz inerte, tel que de l'argon, à pression voisine de la pression atmosphérique, et pour lequel l'élément témoin (4) est une couche de cuivre ou de titane obtenue par gravure chimique sélective ou par dépôt sélectif par évaporation sous vide sur une partie de la surface intérieure de chaque capot (3) ou sur une partie de chaque zone du substrat (2), **caractérisé en ce que** l'enceinte (30) est remplie d'oxygène en tant que fluide réactif à une pression supérieure à 10 bars, de préférence sensiblement égale à 15 bars ou 20 bars pour que les propriétés optiques de la couche de cuivre ou de titane se modifient par oxydation en fonction de la quantité d'oxygène ayant pénétré dans la cavité pendant la période de temps déterminée.

6. Procédé selon la revendication 5, **caractérisé en ce qu'**après la période de temps déterminée et avant l'opération de contrôle des propriétés optiques de la couche (4) de cuivre ou de titane, l'enceinte (30) est dépressurisée et ouverte, **en ce que** le composant micrométrique (1) ou au moins une plaquette (1') de composants micrométriques est retiré de l'enceinte et placé sur un support mobile (51) d'une machine de mesure (50) pour le contrôle de l'herméticité, et **en ce que** pour le contrôle de l'herméticité, au moins un faisceau de lumière (IR) de longueur d'onde déterminée, qui est émis par une source de lumière (20) de la machine de mesure, est dirigé vers la couche de cuivre ou de titane, afin d'être capté par un capteur d'image (21) de la machine de mesure par réflexion du faisceau de lumière sur la couche de cuivre ou de titane ou par transmission du faisceau de lumière à travers le composant micrométrique en passant par la couche de cuivre ou de titane, le substrat et/ou le capot étant transparent au faisceau de lumière de longueur d'onde déterminée.

7. Procédé selon la revendication 6, pour lequel la structure de chaque composant micrométrique est un micro-contacteur magnétique (5, 6, 10) qui comprend une première lame conductrice (6), dont une extrémité est solidaire du substrat par l'intermédiaire d'un pied conducteur (5), et l'autre extrémité de la première lame est libre de mouvement pour venir en contact avec une seconde lame conductrice (10) fixée sur le substrat (2) en présence d'un champ magnétique, une partie intermédiaire de la première lame ayant une ouverture (7) s'étendant sur la majeure partie de sa longueur, la distance séparant le pied de la première lame et une extrémité de la seconde lame correspondant à la longueur de l'ouverture, et pour lequel la couche (4) de cuivre ou de titane distante et en regard de l'ouverture (7) a une épaisseur comprise entre 10 et 100 nm, de préférence 30 nm, et une surface de dimension inférieure à la dimension de la surface de l'ouverture pour définir à travers l'ouverture des première et seconde zones de mesure, **caractérisé en ce que** pour le contrôle des propriétés optiques de la couche de cuivre ou de titane, un premier faisceau de lumière (IR1) émis par la source de lumière (20) traverse le composant micrométrique (1) en passant par la première zone de mesure à travers la couche de cuivre ou de titane afin d'être capté par le capteur d'image (21) de la machine (50), **en ce qu'**un second faisceau de lumière (IR2) émis par la source de lumière traverse le composant micrométrique en passant par la seconde zone de mesure sans traverser la couche de cuivre ou de titane afin d'être capté par le capteur d'image, et **en ce que** des moyens de traitement de la machine de mesure déterminent par comparaison d'intensités lumineuses des premier et second faisceaux captés par le capteur d'image un taux de fuite de la cavité du composant micrométrique.

8. Procédé selon l'une des revendications 6 et 7, pour lequel le substrat (2) et/ou le capot (3) de chaque composant micrométrique (1) est en silicium, **caractérisé en ce que** les premier et second faisceaux de lumière (IR1, IR2) sont émis par la source de lumière (20) avec une longueur d'onde de l'ordre de 1,3 µm.

9. Procédé selon l'une des revendications 6 et 7, pour lequel le substrat (2) et/ou le capot (3) de chaque composant micrométrique (1) est en verre, **caractérisé en ce que** les premier et second faisceaux de lumière (IR1, IR2) sont émis par la source de lumière (20) avec une longueur d'onde dans le domaine infrarouge proche, notamment proche de 850 nm.

10. Composant micrométrique (1) convenant à la mise en oeuvre du procédé selon l'une des revendications 1 ou 3 à 9, le composant comprenant une structure (5, 6, 10) réalisée sur ou dans une portion d'un substrat (2) et un capot (3) fixé sur une zone du substrat pour protéger la structure, une cavité close (14) étant délimitée par la surface intérieure du capot, la structure et la zone du substrat, **caractérisé en ce qu'**il comprend à l'intérieur de la cavité une couche de cuivre en tant qu'élément témoin (4, 15) pour un contrôle par voie optique de l'herméticité de ladite cavité du composant, les propriétés optiques de la couche de cuivre pouvant changer de manière permanente en présence d'un fluide réactif, qui est de l'oxygène, et **en ce que** l'épaisseur de la couche (4) de cuivre est comprise entre 10 et 100 nm, de préférence égale à 30 nm pour pouvoir changer de couleur et de transparence à une longueur d'onde déterminée de lumière, en présence d'oxygène dans la cavité close.

11. Composant micrométrique (1) selon la revendication 10, **caractérisé en ce que** la cavité (14) comprend un gaz inerte, tel que l'argon, à pression voisine de la pression atmosphérique, et **en ce que** la couche de cuivre est obtenue par gravure chimique sélective ou par dépôt sélectif par évaporation sous vide sur une partie de la surface intérieure du capot (3) ou sur une partie de la zone du substrat (2).

12. Composant micrométrique (1) selon la revendication 10, **caractérisé en ce que** la structure est un micro-contacteur magnétique (5, 6, 10) qui comprend une première lame conductrice (6), dont une extrémité est solidaire du substrat (2) par l'intermédiaire d'un pied conducteur (5), et l'autre extrémité de la première lame est libre de mouvement pour venir en contact avec une seconde lame conductrice (10) fixée sur le substrat en présence d'un champ magnétique, une partie intermédiaire de la première lame ayant une ouverture (7) s'étendant sur la majeure partie de sa longueur, la distance séparant le pied de la première lame et une extrémité de la seconde lame correspondant à la longueur de l'ouverture, et **en ce que** la couche (4) de cuivre distante et en regard de l'ouverture (7) a une surface de dimension inférieure à la dimension de la surface de l'ouverture pour définir à travers l'ouverture des première et seconde zones de mesure pour le passage de faisceaux de lumière de contrôle de l'herméticité.

13. Composant micrométrique (1) selon la revendication 10, **caractérisé en ce que** le substrat (2) et/ou le capot (3) sont en verre ou en silicium.

## Claims

1. Method for checking the hermeticity of a closed cavity (14) of at least one micrometric component (1) which includes a structure (5, 6, 10) made on or in a portion of a substrate (2) and a cap (3) fixed onto a zone of the substrate to protect the structure, the cavity being delimited by the inner surface of the cap, the structure and the zone of the substrate, the method being **characterized in that** it includes steps of:
- placing the micrometric component (1) in a container (30), said component including inside the cavity (14) an indicator element (4) for checking hermeticity whose optical properties change permanently in the presence of a reactive fluid capable of reacting with the indicator element,
- hermetically sealing the container that contains said component,
- filling the container with a reactive fluid under pressure in order to subject said component to a higher fluid pressure to the pressure in the cavity for a determined time period, such as several days, the container including means (35 to 39) for introducing the reactive fluid, and
- checking the variation in the properties of the indicator element (4) by optical means as a function of the quantity of reactive fluid that has penetrated the cavity (14) and reacted with the indicator element to determine the hermeticity of said cavity.

2. Method for measuring the hermeticity of a closed cavity (14) of at least one micrometric component (1) which includes a structure (5, 6, 10) made on or in one portion of a substrate (2) and a cap (3) fixed onto a zone of the substrate to protect the structure, the cavity being delimited by the inner surface of the cap, the structure and the zone of the substrate, the cavity including an inert gas, such as argon, at a pressure close to the atmospheric pressure, the method being **characterized in that** it includes steps of:
- placing the micrometric component (1) in a container (30), said component including, inside the cavity, an indicator element (15) for checking hermeticity whose electrical properties change permanently in the presence of a reactive fluid capable of reacting with the indicator element, said indicator element being a palladium resistor made on one part of the zone of the substrate, insulated conductive paths (16, 18) connecting the resistor and passing through the micrometric component for checking the electrical properties,
- hermetically sealing the container that contains said component,
- filling the container with a reactive fluid, which is hydrogen, under pressure in order to subject said component to a higher fluid pressure than 10 bars, preferably substantially equal to 15 bars or 20 bars, so that the value of the palladium resistor is altered as a function of the quantity of hydrogen that has penetrated the cavity during a determined time period, such as several days, the container including means (35 to 39) for introducing the hydrogen, and
- electrically checking the variation in the electrical properties of the palladium resistor as a function of the quantity of hydrogen fluid that has penetrated the cavity and reacted with the palladium resistor to determine the hermeticity of said cavity.

3. Method according to any of the preceding claims, **characterized in that** several wafers (1') that each include several micrometric components (1) made on the same substrate (2) and having a plate (3') of caps (3) fixed to the substrate to enclose each structure of micrometric components, are placed in the container (30) to be placed under pressure by the reactive fluid introduced into the container for a determined time period.

4. Method according to claim 3, **characterized in that** the interior of the container (30) filled with reactive fluid is heated to a temperature higher than the ambient temperature, preferably to a temperature higher than 100°C by heating means (40, 41) during the determined time period.

5. Method according to claim 1, wherein the cavity (14) of the micrometric component (1) or each cavity of micrometric components made on a same substrate (2) of at least one wafer (1') and having a plate (3') of caps (3) fixed to the substrate to enclose each micrometric component structure, includes an inert gas, such as argon, at a pressure close to the atmospheric pressure, and wherein the indicator element (4) is a copper or titanium layer obtained by selective chemical etching or by selective deposition by evaporation under vacuum over one part of the inner surface of each cap (3) or over one part of each zone of the substrate (2), **characterized in that** the container (30) is filled with oxygen as the reactive fluid at a higher pressure than 10 bars, preferably substantially equal to 15 bars or 20 bars so that the optical properties of the copper or titanium layer are altered by oxidisation as a function of the quantity of oxygen that has penetrated the cavity during the determined time period.

6. Method according to claim 5, **characterized in that** after the determined time period and before the operation of checking the optical properties of the copper or titanium layer (4), the container (30) is depressurised and opened, **in that** the micrometric component (1) or at least one wafer (1') of micrometric components is removed from the container and placed on a moving support (51) of a measuring machine (50) for the hermeticity check, and **in that** for the hermeticity check, at least one light beam (IR) on a determined wavelength, which is emitted by a light source (20) of the measuring machine, is directed towards the copper or titanium layer, so as to be picked up by an image sensor (21) of the measuring machine by reflection of the light beam on the copper or titanium layer or by transmission of the light beam through the micrometric component passing through the copper or titanium layer, the substrate and/or the cap being transparent to the light beam on the determined wavelength.

7. Method according to claim 6, wherein the structure of each micrometric component is a magnetic microcontactor (5, 6, 10) which includes a first conductive strip (6), one end of which is secured to the substrate by a conductive foot (5), and the other end of the first strip is free to move to come into contact with a second conductive strip (10) fixed to the substrate (2) in the presence of a magnetic field, an intermediate part of the first strip having an aperture (7) extending over most of its length, the distance separating the foot of the first strip and one end of the second strip corresponding to the length of the aperture, and wherein the copper or titanium layer (4), which is at distance from and opposite the aperture (7), has a thickness comprised between 10 and 100 nm, preferably 30 nm, and a surface dimension less than the surface dimension of the aperture to define through the aperture first and second measuring zones, **characterized in that**, for checking the optical properties of the copper or titanium layer, a first light beam (IR) emitted by the light source (20) passes through the micrometric component (1) passing through the first measurement zone through the copper or titanium layer to be picked up by the image sensor (21) of the machine (50), **in that** a second light beam (IR2) emitted by the light source passes through the micrometric component passing through the second measurement zone without passing through the copper or titanium layer in order to be picked up by the image sensor, and **in that** processing means of the measuring machine determine a leakage rate of the micrometric component cavity by comparing the luminous intensity of the first and second beams picked up by the image sensor

8. Method according to any of claims 6 and 7, wherein the substrate (2) and/or the cap (3) of each micrometric component (1) is made of silicon, **characterized in that** the first and second light beams (IR1, IR2) are emitted by the light source (20) with a wavelength of the order of 1.3 µm.

9. Method according to any of claims 6 and 7, wherein the substrate (2) and/or the cap (3) of each micrometric component (1) is made of glass, **characterized in that** the first and second light beams (IR1, IR2) are emitted by the light source (20) in the near infrared range, close to 850 nm.

10. Micrometric component (1) suitable for implementing the method according to any of the claims 1 or 3 to 9, the component including a structure (5, 6, 10) made on or in one portion of a substrate (2) and a cap (3) fixed to one zone of the substrate to protect the structure, a closed cavity (14) being delimited by the inner surface of the cap, the structure and the zone of the substrate, **characterized in that** it includes, inside the cavity, a copper layer, such as an indicator element (4, 15) for checking via optical means, hermeticity of said cavity of the component, optical properties of the copper layer capable of changing permanently in the presence of a reactive fluid, which is oxygen, **in that** the thickness of the copper layer (4) is comprised between 10 and 100 nm, preferably equal to 30 nm, to be able to change colour and transparency at a determined light wavelength, in presence of oxygen in the closed cavity.

11. Micrometric component (1) according to claim 10, **characterized in that** the cavity (14) includes an inert gas, such as argon, at a pressure close to the atmospheric pressure, and **in that** the copper layer is obtained by selective chemical etching or by selective deposition by evaporation under vacuum over one part of the inner surface of the cap (3) or over one part of the zone of the substrate (2).

12. Micrometric component (1) according to claim 10, **characterized in that** the structure is a magnetic microcontactor (5, 6, 10) which includes a first conductive strip (6), one end of which is secured to the substrate (2) by a conductive foot (5), and the other end of the first strip is free to move to come into contact with a second conductive strip (10) fixed to the substrate in the presence of a magnetic field, an intermediate part of the first strip having an aperture (7) extending over most of its length, the distance separating the foot of the first strip and one end of the second strip corresponding to the length of the aperture, and **in that** the copper layer (4), which is at a distance from and opposite the aperture (7), has a surface dimension less than the surface dimension of the aperture to define, through the aperture, first and second measuring zones for the passage of light beams for checking hermeticity.

13. Micrometric component (1) according to claim 10, **characterized in that** the substrate (2) and/or the cap (3) are made of glass or silicon.

## Patentansprüche

1. Verfahren zum Kontrollieren der Dichtheit eines geschlossenen hohlraums (14) wenigstens eines mikrometrischen Bauteils (1), das eine Struktur (5, 6, 10), die auf oder in einem Anschnitt eines Substrats (2) verwirklicht ist, und eine Haube (3), die auf einer Zone des Substrats befestigt ist, um die Struktur zu schützen, umfasst, wobei der Hohlraum durch die innere Oberfläche der Haube, die Struktur und die Zone des Substrats begrenzt ist, wobei das Verfahren **dadurch gekennzeichnet ist, dass** es die Schritte umfasst, die darin bestehen:
das mikrometrische Bauteil (1) in einem Behälter (30) anzuordnen, wobei das Bauteil innerhalb des Hohlraums (14) ein Kontrollelement (4) zur Kontrolle der Dichtheit aufweist, dessen optische Eigenschaften sich in Gegenwart eines reaktiven Fluid, das mit dem Kontrollelement reagieren kann, ständig ändern,
- den Behälter, der das Bauteil enthält, hermetisch zu verschließen,
- den Behälter mit einem reaktiven Fluid unter Druck zu füllen, um das Bauteil mit einem Fluiddruck, der größer als der Druck in dem Hohlraum ist, während einer bestimmen Zeitdauer, etwa mehrere Tage, zu beaufschlagen, wobei der Behälter Mittel (35 bis 39) zum Einleiten des reaktiven Fluides aufweist, und
- die Veränderung der Eigenschaften des Kontrollelements (4) auf optischem Weg entsprechend der Menge des reaktiven Fluids, das in den Hohlraum (14) eingedrungen ist und mit dem Kontrollelement reagiert hat, zu kontrollieren, um die Dichtheit des Hohlraums zu bestimmen.

2. Verfahren zum Messen der Dichtheit eines geschlossenen Hohlraums (14) wenigstens eines mikrometrischen Bauteils (1), das eine Struktur (5, 6, 10), die auf oder in einem Abschnitt eines Substrats (2) verwirklicht ist, und eine Haube (3), die auf einer Zone des Substrats befestigt ist, um die Struktur zu schützen, umfasst, wobei der Hohlraum durch die innere Oberfläche der Haube, die Struktur und die Zone des Substrats begrenzt ist, wobei der Hohlraum ein Edelgas wie etwa Argon mit einem Druck in der Umgebung des Atmosphärendrucks enthält, wobei das Verfahren **dadurch gekennzeichnet ist, dass** es die Schritte umfasst, die darin bestehen:
- das mikrometrische Bauteil (1) in einem Behälter (30) anzuordnen, wobei das Bauteil in dem Hohlraum ein Kontrollelement (15) zur Kontrolle der Dichtheit aufweist, dessen elektrische Eigenschaften sich in Gegenwart eines reaktiven Fluids, das mit dem Kontrollelement reagieren kann, ständig ändern, wobei das Kontrollelement ein Widerstand aus palladium ist, der auf einem Teil der Zone des Substrats verwirklicht ist, wobei isolierte Leiterbahnen (16, 18) den Widerstand verbinden und durch das mikrometrische Bauteil verlaufen, um die elektrischen Eigenschaften zu kontrollieren,
- den Behälter, der das Bauteil enthält, hermetisch zu verschließen,
- den Behälter mit einem reaktiven Fluid, das Wasserstoff ist und unter Druck steht, zu füllen, um das Bauteil mit einem Wasserstoffdruck größer als 10 Bar, vorzugsweise im Wesentlichen gleich 15 Bar oder 20 Bar, zu beaufschlagen, damit sich der Wert des Palladiumwiderstands entsprechend der Wasserstoffmenge, die während einer bestimmten Zeitdauer, etwa einige Tage, in den Hohlraum eingedrungen ist, verändert, wobei der Behälter Mittel (35 bis 39) zum Ein-leiten des Wasserstoffs enthält, und
- die Veränderung der elektrischen Eigenschaften des Palladiumwiderstands entsprechend der Wasserstoffmenge, die in den Hohlraum eingedrungen ist und mit dem Palladiumwiderstand reagiert hat, elektrisch zu kontrollieren, um die Dichtheit des Hohlraums zu bestimmen.

3. Verfahren nach einem der vorhergehenden Ansprüche, **dadurch gekennzeichnet, dass** im Behälter (30) mehrere Scheiben (1') angeordnet sind, die jeweils mehrere mikrometrische Bauteile (1) umfassen, die auf demselben Substrat (2) verwirklicht sind, und eine Platte (3') von Hauben (3), die auf dem Substrat befestigt ist, um jede Struktur der mikrometrischen Bauteile zu zum schließen, aufweisen, um die Scheiben (1') durch das reaktive Fluid, das in den Behälter eingeleitet wird, während einer bestimmten Zeitdauer mit Druck zu beaufschlagen.

4. Vorfahren nach Anspruch 3, **dadurch gekennzeichnet, dass** der Innenraum des Behälters (30), der mit dem reaktiven Fluid gefüllt ist, während der bestimmten Zeitdauer durch Heizmittel (40, 41) auf eine Temperatur oberhalb der Umgebungstemperatur, vorzugsweise auf eine Temperatur größer als 100 °C, erhitzt wird.

5. Verfahren nach Anspruch 1, wobei der Holraum (14) des mikrometrischen Bauteils (1) oder jeder Hohlraum mikrometrischer Bauteile, die auf demselben Substrat (2) wenigstens einer Scheibe (1') verwirklicht sind und jeweils eine Platte (3') von Hauben (3) besitzen, die auf dem Substrat befestigt ist, um jede Struktur mikrometrischer Bauteile zu umschließen, ein Edelgas wie etwa Argon mit einem Druck in der Nähe des Atmosphärendrucks enthält und wobei das Kontrollelement (4) eine Kupfer- oder Titanschicht ist, die durch selektives chemisches Ätzen oder durch selektive Abscheidung aus der Dampfphase im Vakuum auf einem Teil der inneren Oberfläche jeder Haube (3) oder auf einem Teil jeder Zone des Substrats (2) erhalten wird, **dadurch gekennzeichnet, dass** der Behälter (30) mit Sauerstoff als reaktivem Fluid auf einem Druck oberhalb von 10 Bar, vorzugsweise im Wesentlichen gleich 15 Bar oder 20 Bar, gefüllt ist, damit sich die optischen Eigenschaften der Kupfer- oder Titanschicht durch Oxydation entsprechend der Menge von Sauerstoff, die während der vorgegebenen Zeitdauer in den Hohlraum eingedrungen ist, verändern.

6. Verfahren nach Anspruch 5, **dadurch gekennzeichnet, dass** nach der vorgegebenen Zeitdauer und vor der Ausführung der Kontrolle der optischen Eigenschaften der Kupfer- oder Titanschicht (4) der Behälter (30) druckentlastet und geöffnet wird, dass das mikrometrische Bauteil (1) oder wenigstens eine Scheibe (1') mikrometrischer Bauteile aus dem Behälter entnommen und auf einem bewegliche Träger (51) einer Messmaschine (50) anbeordnet wird, um die Dichtheit zu kontrollieren, und dass für die Kontrolle der Dichtheit wenigstens ein Lichtstrahlenbündel (IR) mit bestimmter Wellenlänge, das von einer Lichtquelle (20) der Messmaschine ausgesendet wird, zu der Tupfer- oder Titanschicht gelenkt wird, um von einem Bildsensor (21) der Messmaschine durch Reflexion des Lichtstrahlenbündels auf der Kupfer- oder Titanschicht oder durch Durchlassen des Lichtstrahlenbündels durch das mikrometrische Bauteil, indem es durch die Kupfer- oder Titanschicht verläuft, erfasst zu werden, wobei das Substrat und/oder die Haube für das Lichtstrahlenbündel mit bestimmter Wellenlänge durchlässig sind.

7. Verfahren nach Anspruch 6, wobei die Struktur jedes mikrometrischen Bauteils ein magnetischer Mikrokontaktgeber (5, 6, 10) ist, der eine erste leitende Lamelle (6) umfasst, wovon ein Ende über einen Leiterfuß (5) mit dem Substrat verbunden ist, während das anders Ende der ersten Lamelle frei beweglich ist, um mit einer zweiten leitenden Lamelle (10), die an dem Substrat (2) befestigt ist, in Gegenwart eines Magnetfeldes in Kontakt zu gelangen, wobei ein Zwischenabschnitt der ersten Lamelle eine Öffnung (7) besitzt, die sich über den größten Teil ihrer Länge erstreckt, wobei der Abstand, der den Fuß der ersten Lamelle und ein Ende der zweiten Lamelle trennt, der Länge der Öffnung entspricht, und wobei die Kupfer- oder Titanschicht (4) entfernt von und gegenüber der Öffnung (7) eine Dicke im Bereich von 10 bis 100 nm, vorzugsweise 30 nm, und eine Oberflächenabmessung, die kleiner als die Abmessung der Oberfläche der Öffnung ist, um durch die Öffnung eine erste und eine zweite Messzone zu definieren, besitzt, **dadurch gekennzeichnet, dass** für die Kontrolle der optischen Eigenschaften der Kupfer- oder Titanschicht ein erstes Lichtstrahlenbündel (IR1), das von der Lichtquelle (20) ausgesendet wird, durch das mikrometrische Bauteil (1) verläuft, indem es sich durch die erste Messzone durch die Kupfer- oder Titanschicht bewegt, um von dem Bildsensor (21) der Maschine (50) erfasst zu werden, dass ein zweites Lichtstrahlenbündel (IR2), das von der Lichtquelle ausgesendet wird, durch das mikrometrische Bauteil verläuft, indem es sich durch die zweite Messzone bewegt, ohne durch die Kupfer- oder Titanschicht zu verlaufen, um von dem Bildsensor erfasst zu werden, und dass Verarbeitungsmittel der Messmaschine durch Vergleichen der Lichtintensitäten des ersten und des zweiten Strahlenbündels, dir von dem Bildsensor erfasst werden, einen Verlustanteil des Hohlraums des mikrometrischen Bauteils bestimmen.

8. Verfahren nach einem der Ansprüche 6 und 7, wobei das Substrat (2) und/oder die Haube (3) jedes mikrometrischen Bauteils (1) aus Silicium besteht, **dadurch gekennzeichnet, dass** das erste und das zweite Lichtstrahlenbündel (IR1, IR2) durch die Lichtquelle (20) mit einer Wellenlänge in der Größenordnung von 1,3 µm ausgesendet werden.

9. Verfahren nach einem der Ansprüche 6 und 7, wobei das Substrat (2) und/oder die Haube (3) jedes mikrometrischen Bauteils (1) aus Glas bestehen, **dadurch gekennzeichnet, dass** das erste und das zweite Lichtstrahienbündei (IR1, IR2) von der Lichtquelle (20) mit einer Wellenlänge im Bereich des nahen Infrarot, insbesondere in der Nähe von 850 nm, ausgesendet werden.

10. Mikrometrisches Bauteil (1), das für die Ausführung des Verfahrens nach einem der Ansprüche 1 oder 3 bis 9 geeignet ist, wobei das Bauteil eine Struktur (5, 6, 10), die auf oder in einem Abschnitt eines Substrats (2) verwirklicht ist, und eine Haube (3), die an einer Zone des Substrats befestigt ist, um die Struktur zu schützen umfasst, wobei ein geschlossener Hohlraum (14) durch die innere Oberfläche der Haube, die Struktur und die Zone des Substrats begrenzt ist, **dadurch gekennzeichnet, dass** es in dem Hohlraum eine Kupferschicht als Kontrollelement (4, 15) für eine Kontrolle auf optischem Weg der Dichtheit des Hohlraums des Bauteils aufweist, wobei sich die optischen Eigenschaften der Kupferschicht in Gegenwart eines reaktiven Fluid, das Sauerstoff ist, ständig ändern könnten, und dass die Dicke der Kupferschicht (4) im Bereich von 10 bis 100 nm liegt und vorzugsweise gleich 30 nm ist, um die Farbe und die Durchlässigkeit für eine bestimmte Wellenlänge des Lichts in Gegenwart von Sauerstoff in dem geschlossenen Hohlraum wandern zu können.

11. Mikrometrisches Bauteil (1) nach Anspruch 10, **dadurch gekennzeichnet, dass** der Hohlraum (14) ein Edelgas wie etwa Argon mit einem Druck in der Umgehung des Atmosphärendrucks enthält und dass die Kupferschicht durch selektives chemische Ätzen oder durch selektive Abscheidung aus der Dampfphase im Vakuum auf einem Teil der inneren Oberfläche der Haube (3) oder auf einem Teil der Zone des Substrats (2) erhalten wird.

12. Mikrometrisches Bauteile (1) nach Anspruch 10, **dadurch gekennzeichnet, dass** die Struktur ein magnetische Mikrokontaktgeber (5, 6, 10) ist, der eine erste leitende Lamelle (6) umfasst, wovon ein Ende mit dem Substrat (2) über einen Leiterfuß (5) verbunden ist, während das andere Ende der ersten Lamelle frei beweglich ist, um in Gegenwart eines Magnetfelds mit einer zweiten leitenden Lamelle (10), die auf dem Substrat, befestigt ist, in Kontakt zu gelangen, wobei ein Zwischenabschnitt der ersten Lamelle eine Öffnung (7) aufweist, die sich über den Hauptteil ihrer Lange erstreckt, wobei der Abstand, der den Fuß der ersten Lamelle und ein Ende der zweiten Lamelle trennt, der Länge der Öffnung entspricht, und dass die Kupferschicht (4) entfernt von rand gegenüber der Öffnung (7) eine Oberflächenabmessung besitzt, die kleiner als die Abmessung der Oberfläche der Öffnung ist, um durch die Öffnung eine erste und eine zweite Messzone für den Durchgang von Lichtstrahlenbündeln für die Kontrolle der Dichtheit zu definieren.

13. Mikrometrisches Bauteil (1) nach Anspruch 10, **dadurch gekennzeichnet, dass** das Substrat (2) und/oder die Haube (3) aus Glas oder aus Silicium bestehen.
